# EUROPEAN PATENT SPECIFICATION

(11) **EP 1 653 609 B1**
(45) Date of publication and mention of the grant of the patent: **05.03.2008**
(21) Application number: 05023505.0
(22) Date of filing: 27.10.2005
(51) Int. Cl.: H03G 3/30

(54) **TV reception headend, with circuit for automatic control of output levels**
Kopfstelle zum Empfang von Fernsehsignalen, mit einer Schaltung zur automatischen Regelung der Ausgangsamplitude
Tête de réseau pour la réception des signaux de télévision, avec un circuit pour le réglage automatique des niveaux de sortie

(30) Priority: 27.10.2004 ES 200402578
(43) Date of publication of application: 03.05.2006
(73) Proprietor: FAGOR, S.COOP., 20500 Mondragon (Gipuzkoa) (ES)
(72) Inventor: Isasi Zamalloa, Ricardo, 48200 Durango (Bizkaia) (ES)
(74) Representative: Fernandez Guzman, Juan

(56) References cited:
- US-A- 3 978 422
- US-A- 4 987 606
- US-A- 5 321 849
- US-B1- 6 788 744

## Description

### Technical field

The present invention relates to the reception and transmission of RF signals from collective TV aerials and cable television networks CATV, comprising a reception headend with a plurality of processing modules of the input channels signals and with an automatic gain control (AGC) applied to the signal processors.

### Prior art

The reception headend of collective TV installations and of CATV cable networks, wherein it is necessary to maintain constant the output level of the signal in each channel processor of the headend, to guarantee the availability of the service offered by the operator in the user's TV sockets are known. The output level variation depends on the input power level variations and on the variation of the processor transfer function, which is generally caused by variations in the physical propagation path, ambient temperature, supply voltage, etc.

The output level of each processor is obtained in the known TV headends, by the inclusion of an automatic gain control circuit -AGC- in each channel signal processor. The AGC loop in a channel signal processor in a TV headend must look for the balance between the error in the output level, the stability with respect to transients and the distortion in the intelligent signal.

This function depends on the type of modulation of the carrier signal received in the headend, on the bandwidth of the intelligent signal and on the type of processor, whether the latter be stationary or mobile. The case of the situations with the presence of adjacent channels "n-3 to n+3" at the input is critical in order to obtain a constant output level "L" in channel "n". In the TV headend of the prior art, band selecting of each processor is conditioned by its own circuit, provided by the tuneable filters, any of which can be affected by the presence of the adjacent channels, making their selectivity "insufficient". The precision obtained in the gain control (AGC) of each headend processor depends on the processor "sufficient selectivity".

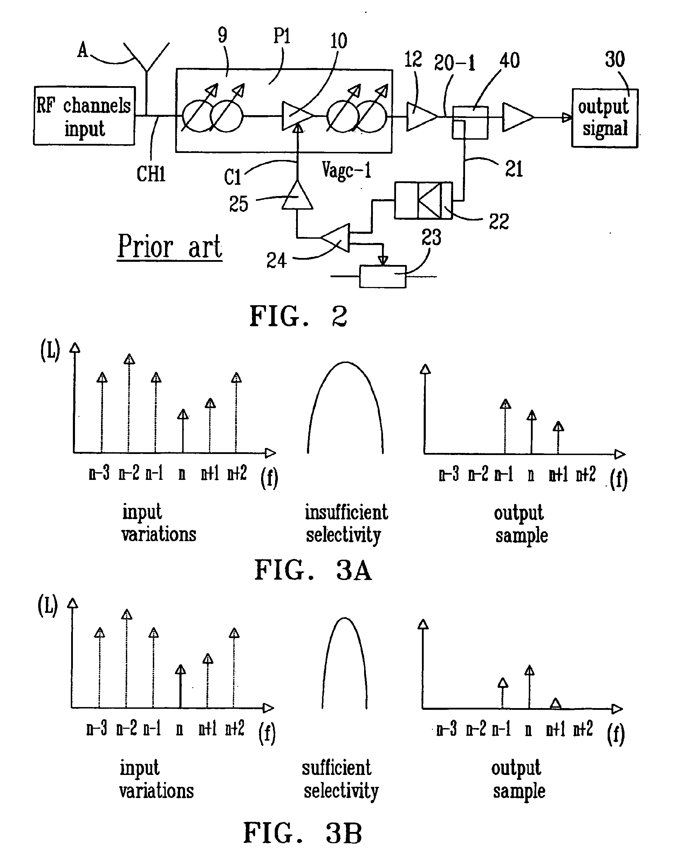

Figure 2 shows a scheme of a channel signal processor with a selective amplifier and a AGC circuit, of a TV reception headend belonging to the prior art, where P1 is an individual channel processor among n processors, comprising at least one tuneable channel filter, in this example two filters 9,11 interconnected to a variable gain amplifier 10 (VGA), a fixed gain amplifier 12, an individual line 20-1 for specific processor P1 signal transmission, a sample socket 40, a detector 22, a reference voltage 23, a comparator 24, a dc voltage amplifier 25, and an individual line C1 of the particular control voltage Vagc-1 applied to the corresponding processor P1. Each processing module P1-Pn, in the same number as the "n" reception tuned channels of the TV reception headend, incorporates a AGC loop like that featured in FIG. 2 from an individual line 20-1 to 20-n. For the stationary processors the AGC loop response time is usually high -from tenths of a second to seconds -, and the gain high, and therefore the error in the output signal 30 level is low -fractions of dB-.

The AGC loop circuit represented in FIG. 2, works by modifying the amplification chain gain 9-12 of only one signal processor P1, until it equalises the output level of the specified channel to a reference level. The channel signal 20-1 output level is converted from the sample 21 to a Vdc voltage for its comparison with a prefixed reference Vdc voltage value 23. The Vdc voltage equivalent to the controlled output level must be determined depending on the "L" level of the specified channel, without any input level contributions from the adjacent channels n-3 to n-1 and n+1 to n+3, as is represented in FIG. 3A. I.e. the same processor P1-Pn provides the "rejection of adjacent channels effect". Adjacent channel rejections greater than 20 dB are considered necessary in collective aerial and Cable TV networks. The signal resultant difference is also termed error signal, and controls the gain of the amplification chain 9-12 of the processor P1 thus closing the loop of the AGC 40, 25, C1.

FIGS. 3A and 3B represent the concept of frequency selectivity. The processor P1 selectivity like the one represented in FIG. 2, is a determining factor so that the output level "L" of channel "n" is not affected by the fluctuations of the adjacent channels in the CH1 input. If in the processor P1 input several adjacent channels "n-3 to n+3" (FIG. 3A) are present, with "not sufficient" inherent selectivity in the processor, the sample 21 of signal will be proportional to level "L" of all the "n" channels present in the input, and the variation of any of them will alter the output level of the tuned channel, in this example CH1; whose level we are trying to maintain. In the individual AGC circuit 21-25,C1 in FIG. 2, with the adjacent channel input levels being measured together with the channel CH1 nominal level, the precision of the value of the dc voltage generated for the AGC of the processor P1 will be wrong when the adjacent channels level is the same or greater than the nominal level of the CH1 processed channel.

US-A-6148189 describes a RF channel signal processor for a TV receiver, with an independent AGC voltages generator block, for one only processor.

US2003/0026364-A1 describes a RF channel digital or analogue signal processor for a TV receiver, with a generator of only one AGC, and includes the information of the RF channels map on a memory.

On the other hand patent ES-A2117953, deals with an automatic equalisation circuit of channel filters amplifiers output signals, which is carried out, unlike the automatic gain control, at a prior adjustment stage of the filters, before these come into service.

To obtain this equalisation corresponding gain voltages are applied to the variable gain amplifiers, by means of a single gain adjustment circuit to control a plurality of TV channel amplifiers, carrying it out for each amplifier individually, selecting the amplifier to be controlled by a selector.

US-A-3978422 discloses a broadband automatic gain control amplifier comprising several transistor amplifiers and incorporating a plurality of gain-controlling components connected in parallel and exercising gain control at the interstage connections between all the amplifiers so providing control loops, each responsive to signal levels at the output of the gain control amplifier at different frequencies for developing a control signal to correct the output signal level simultaneously at that frequency and at other frequencies.

US-A-5321849 discloses a system for controlling signal level at both ends of a transmission link, comprising a control device controlling a first signal level changing device and a second signal level changing device in response to a detected level of a transmit signal adapted to be transmitted over the transmission link. A combining unit assimilates all information input and forms output signals which are sent to attenuation control unit to control the respective settings of the first and second signal level changing devices.

### Disclosure of the invention

The object of the invention is a collective aerial or cable network headend for TV, with only one common AGC circuit for the plurality of channel signal processing modules of the headend, which generates n" Vdc control voltage values in real time, each one being particular to each channel, and applied simultaneously to the corresponding processor, thus the processors pre-established output levels are always maintained constant.

The headend proposed by the present invention is applied to the reception of TV signals through a collective aerial or through a cable network CATV, provided with an automatic gain control of the tuned TV signals output levels, and comprises in combination:
- a plurality of processing modules arranged in parallel, and adapted to simultaneously process analogue or digital input signals of RF channels to be tuned, one channel per processing module, providing each one of said processing modules at least one filtering and each one comprising at least one variable gain amplifier with an application line of voltage gain, and
- an automatic gain control circuit responsible for processing the output signals of said processing modules, with said output signals corresponding to the tuned channels for each one of them, or samples of the same, to check output levels of the processing modules output signals and to generate and apply gain voltages to said application lines of said variable gain amplifiers so as to automatically control said output levels of the output signals of said processing modules, until they are adjusted to certain predetermined values, hence obtaining said control.

Said headend comprises an output or amplification line common to all the processing modules outputs, to which it is connected, directly or through a samples socket (tap), to an input of said automatic gain control circuit, in such a way that all the output signals of said processing modules, or all the samples of said signals, arrive at the same time to the automatic gain control circuit, which is governed by at least one microcontroller for:
- selecting one by one, said output signals of the processing modules or said samples, using highly selective selecting means (to be explained later);
- Carrying out sequentially at least one processing of each one of said signals or selected samples (task carried out by the microcontroller itself), and
- Carrying out sequentially said generation of said gain voltages from the result of said processing of each signal or sample, whose task is carried out by said microcontroller consulting the memory data and with the support of a corresponding D/A converter.

With this obtaining that with only one automatic gain control circuit all the headend processing modules can be controlled without having to interrupt the working of any of them.

In the headend of the invention the selectivity of each processor needs not to be sufficient. The precision of the AGC common circuit becomes independent from the processors selectivity and the fluctuations of the voltage level of the adjacent channels. This is due to the incorporation in said automatic gain control circuit, of selecting means adapted to select, in a sequential manner, said processing modules output signals, or said samples of the same, one by one, through a selectivity characteristic of sufficient frequency so as to disregard the influence of the adjacent channels, at least from n-3 to n+3, being n the nominal channel corresponding to the output signal selected at any time.

The gain control circuit of the headend proposed is provided with a microcontroller with a particular configuration data memory of the analogue and digital RF channels and a low-pass filter, and is designed for the generation of the dc AGC voltage values particular to each processor and in each moment of control, therefore a constant output level of all the signal processors of each channel n, is obtained using only one AGC circuit common to all the processors. The nominal frequency of each channel is sequentially selected from a memory, which is previously provided with reference numeric data corresponding to the required nominal frequencies in the "n" analogue and digital channels of the TV headend.

Input level variations in stationary TV reception systems are slow; therefore the long period of time that passes during an input level variation enables the AGC common circuit of the invention to obtain a control response for the plurality of the TV headend processors. In mobile TV headends this common AGC circuit is not always applicable, due to the speed of the variations of the input levels. One unique circuit provided with a voltages generator block governed by a microcontroller and a reference numeric data memory, controls the "n" processing modules in real time, substituting the "n" individual AGC circuits like that in FIG. 2. For this purpose it is necessary that the generation time of the "n" reference frequencies is less than the response time of each particular AGC.

A common detector is connected to a low-pass filter, in whose input all the "n" channels are present, and in its output only the signal frequency corresponding to a processed nominal channel n, sequentially separated one from the others. The output signal sample of the common detector only contains the "L" level of the specified "n" channel, hence the selectivity of the frequency inherent in each processor is not a determining factor in the precision of the output level "L" achieved, the selectivity being always high. Said stored reference numeric data correspond to each signal frequency of all the channels present, the programmed ones and the possible ones in a determined headend, and are selected in a determined sequence for the generation of each specific gain control voltage Vdc value applied at the time to each processor.

On doing away with an individual AGC circuit, in addition to economic benefits, it provides the headend with a reduction of the overall volume and an improvement in design of an exterior housing of an individual processor module.

### Description of the drawings

Figure 1 shows the scheme of a TV reception headend of the invention.
Figure 2 shows a diagram of a selective amplifier with AGC of a TV reception headend pertaining to the prior art.
Figures 3A and 3B show a representative diagram of the frequency selectivity in the TV reception headend of figure 2.
Figure 4 shows a Vdc sequential voltage generator scheme for the AGC in figure 1.
Figure 5 shows a flow chart of the process followed by the sequential generator of figures 1 and 3.

### Detailed description of the invention

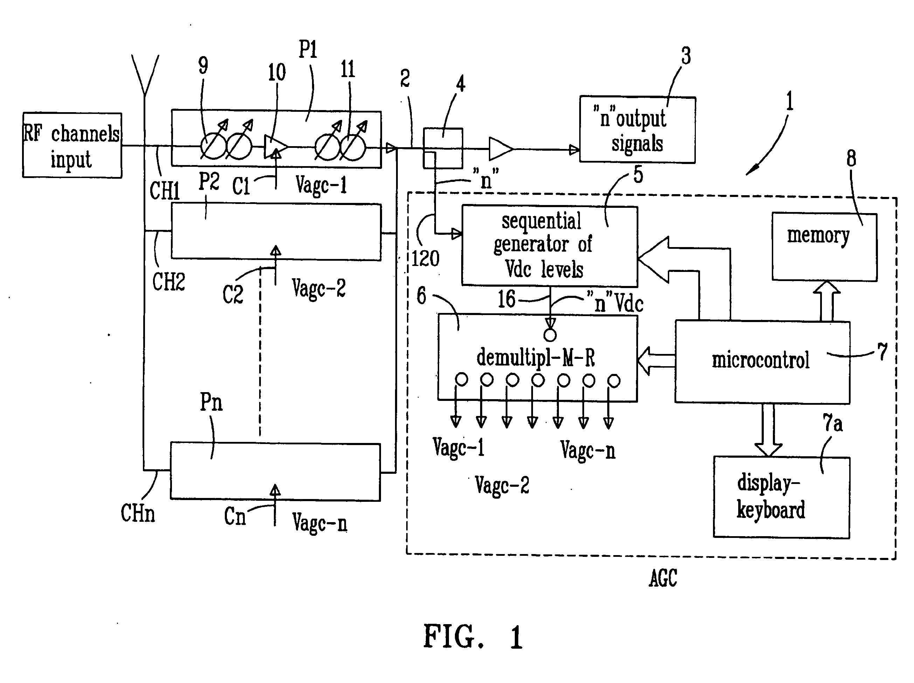

Referring to FIG. 1 and FIGS. 4-5, an embodiment of the headend 1 of TV collective aerial or cable network CATV is described as follows. A SMATV/MATV or CATV headend 1 comprises a plurality of processors P1-Pn, each one having as an example a chain of filters 9,11, and other devices suitable for at least filtering, and at least a variable gain amplifier 10, and they process the signals of "n" tuned channels CH1-CHn. The processors P1-Pn transmit all their amplified signals to a common amplification line 2 and a common output 3 of the TV headend, with each output signal maintaining a level L. A sample of each one of "n" channel signals present is taken by the socket (block 4), and are transmitted to a unique automatic gain control circuit AGC common to all the processors Pn, from a common line 120 of the samples socket 4, to a sequential dc voltage Vdc generator 5, a selecting, sampling and holding block 6, provided with "n" Vagc output terminals, and an automatic control system of the individual signals of each processor Pn. The selecting, holding and addressing block 6, receives the n voltage values Vagc generated from the automatic control system and transmitted, through the generator block 5 to the output 16, it samples them and holds them temporally for their addressing from an individual output connection Vagc-1 to Vagc-n to their corresponding amplification lines C1-Cn of the processing modules P1-Pn, sequentially or for a preferred embodiment, simultaneously.

Output 16 is a continuous succession of as many Vdc voltage "n" levels as channel signals are processed in the TV headend, in the form of a pulse train with each pulse corresponding to one of said Vacg-1 to Vagc-n values. The holding circuit M-R of block 6 presents at each one of its outputs a Vdc voltage pulse proportional to the output level of each processor Pn, and maintains constant the level of each pulse to address them as AGC voltages Vagc-1 to Vagc-n, to the corresponding variable gain amplifier 10, maintaining said voltage levels constant until a possible later refreshment cycle

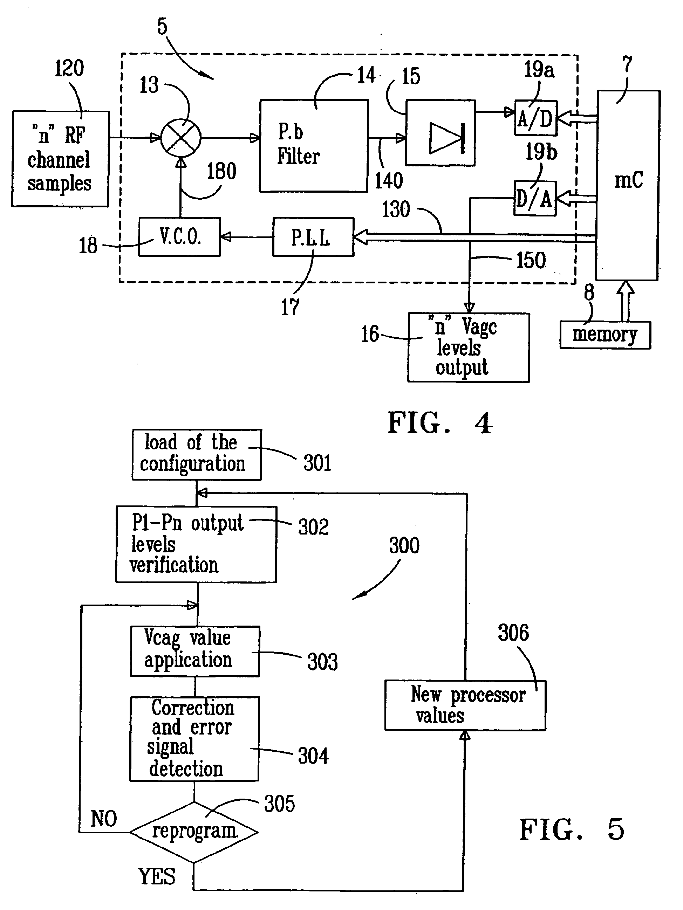

Referring to FIG. 4, the automatic gain control circuit AGC, comprises in the interior of said Vdc voltage generator block 5, and interconnected, a mixer 13, a VCO (Voltage Controlled Oscillator) 18, a P.L.L. (Phase Lock Loop) circuit 17, a low pass filter 14, a detector 15 and associated to block 5 the mentioned automatic control system, formed by a microcontroller 7, a memory 8, and a keyboard display 7a. The group of devices 17, 18 governed by the microcontroller 7 constitutes a frequency synthesizer. The generator block 5 comprises in addition an A/D converter 19a and a D/A converter 19b communicated by a respective microcontroller 7 bus. Both converters 19a, 19b connected to detector 15 and to the microcontroller 7, enable the microcontroller 7 operation controlling the different Vagc depending on the nature of the analogue or digital signals, without the need to use a device for the generation of reference Vdc voltages and their comparison, as each headend processor of the prior art does it (FIG. 2).

The numeric data corresponding to division factors for the P.L.L. circuit is stored on the memory 8 of the ACG common circuit, each one of them corresponding to each reference signal frequency generated, each one representative of all the possible reception channels on the headend, as an example up to 99 different channels for a plurality of geographical areas. On the other side the memory stores the numeric data corresponding to the division factors representative of only the n frequency reference values required by a specific TV headend, for example 16 values (in a certain geographical area) of the n channels tuned on the headend 1 of the installed TV. This last part of the memory with only the required numeric data is selected by the microcontroller 7 from the total store 8, through the keyboard when the installer of the headend carries out the channel programming. The microcontroller 7 extracts this n numeric data for its uninterrupted use in the synthesiser block 7,17,18 and the generation of successive sequences of n frequency reference values, transmitted in the AGC common circuit for the sequential generation of n Vdc values in the output.

At the mixer input 13 the existing n channels are permanently applied. The frequency synthesiser 17, 18 generates n signals of the same frequency f as the n channels that are applied to a line 180 taken to the mixer 13, in a non-interrupted sequential manner. The channel frequency generation sequence f is programmed through the keyboard 7a and is loaded in the memory 8. The microcontroller 7, following the flow diagram sequence in FIG. 5, continually pilots the P.L.L. 17 that controls the voltage controlled oscillator VCO 18 and whose output 180 is permanently applied to the mixer 13. At the mixer output 13 a large amount of signals are present, product of the mix of the n input channels with the sequence of the n signals separated one from the other generated by the VCO 18. The low pass filter 14 has a cut-off frequency lower than half of the channel n bandwidth; filtered at each moment, blocking DC offsets at its input, and selects a level input L that within a sequence corresponds to the programmed channels. From output 140 of the low pass filter 14 only the frequency of the signal corresponding to a channel n is delivered each time, as a result of its coincidence with the channel n frequency generated by the VCO 18, hence obtaining the «sufficient» selectivity characteristic.

The detector 15 delivers Vdc voltage pulses proportional to the levels L of the input channels to an A/D converter 19a. The converter A/D 19a converts the voltage Vdc pulses transmitted by the detector 15 from all the processors P1-Pn to numeric data, and the microcontroller 7 processes this numeric data associated to each input channel CH1-CHn, and modifies them if necessary depending on the analogue or digital nature of the signal, and the level of entry. The modification consists in a comparison with the value table of the data registered, analogue and digital, for each channel tuned in the memory map 8, and the addition or subtraction of an additional Vdc voltage until obtaining the appropriate Vagc voltage for the controlled processor P1-Pn, necessary to obtain the pre-established output level or the direct supply of said voltage Vagc selected from said table. The D/A converter 19b converts the modified numeric data in Vdc voltage pulses, as Vagc output voltages 16 suitable for obtaining the output level of each pre-established channel n, and transmits them to the demultiplexing block 6 for their application to each processor amplification line C1-Cn. In this way the selectivity of the low-pass filter 14 guarantees that the level of the passing signal is proportional only to the specific channel n of each processor P1-Pn, and also when the processor P1-Pn does not have the inherent selectivity necessary to avoid that the pulse levels be altered by the level variation of the adjacent channels n-3 to n+3.

With reference to FIG. 5, a flow diagram 300 has been represented of the process that the microcontroller 7 follows, to emit n AGC voltage values in the common output 16 of the automatic gain control circuit AGC of the n output signals shown in FIG.1 and FIG. 4. The microcontroller 7 has previously loaded the configuration data from the tables contained in the map of RF channels stored in the memory 8 -stage 301-. This information from the map includes a table of reference voltage values, pre-established by the manufacturer of the TV headend 1, for each one of the tuneable channels CH1-CHn, for a plurality of geographical areas of both possible types of signal, analogue or digital. The microcontroller 7 through the bus 130 that communicates with the PLL block 17, controls the latter to carry out a sequential exploration and verification through all the signal frequencies generated by the voltage controlled oscillator VCO 18, of all the channels CH1-CHn programmed in the processors P1-Pn -stage 302-, making an output level comparison of each signal delivered sequentially by the low pass filter 14, with said numeric data registered from the information map of the memory 8, and finding the coincidence to determine the Vagc initial value appropriate for each one of the processors P1-Pn. Then - stage 303- the AGC determined voltages, Vagc-1 to Vagc-n are applied without interruption through the output 16 of the generator block 5, to the block 6 and from here to the supply line C1-Cn of the corresponding AGC of each processor P1-Pn.

In the stage 304 that follows the sampling of the channels CH1-CHn and the sequential application of each one of the Vagc voltages obtained, the microcontroller 7 detects the error signal of the input signal samples 120 of all the channels CH1-CHn previously converted to numeric data by the A/D 19a converter, and carries out a correction modifying them by comparison as described above, and converting them to Vagc voltages in the output 16 through a D/A converter 19b. These voltages Vagc-1 and Vagc-n are already the appropriate values in real time to maintain the n levels of the pre-established signals in the output 3 of the TV headend 1, for the programmed channel CH1-CHn in each processor P1-Pn. In the case of reprogramming -stage 305- some of the processors P1-Pn to a certain channel different from the previous one, a new channel frequency value -stage 306- is assigned to the reprogrammed processor with the new channel value to carry out the routine 302-304 now.

From the aforementioned an operation method is deduced for an automatic gain control circuit applied to control a TV reception headend like that proposed by the invention in order to obtain the desired output signals.

The method comprises the following stages to be carried out for a determined geographical area:
a) Select a table stored in said memory with information referring to said area, said table containing data groups that include the channel to be tuned, the pre-determined level L for the output signal of said tuned channel, and the initial automatic gain control voltage Vagcin;
b) Sequentially select each one of said output signals to acquire information, for each channel, relative at least to:
   i. Output signal frequency of said channel;
   ii. Level L of said output level for the channel.
c) Compare said information acquired for each channel with that contained in each table, and:
   i. Select a Vagcᵢₙ value corresponding to said channel; or
   ii. Modify a previously channel generated value Vagc if the signal level L whose value has been acquired does not coincide with the predetermined one for said channel.
d) Convert each one of said voltage values Vagc or modified Vagc into an analogue value and apply said analogue values, sequentially to said block 6 through said output 16 for their eventual application to the variable amplifiers 10 of each processing module P1.....Pn.
e) Repeat the stages b) c) y d) cyclically in a loop to maintain the control conditions at all times.

Should reprogramming of the channels assigned to the processing module be desired, for example P1.....Pn to change geographical areas, in the stage a), a new table of values corresponding to the new assigned channels will be selected and the remaining stages will be carried out in an analogue manner.

It will be apparent to those skilled in the art that modifications and changes may be made to the examples of the embodiments described without departing from the scope of the present invention which is defined in the following claims.

## Claims

1. TV signals reception headend receiving signals through a collective aerial or by cable network CATV, with automatic gain control of the output levels of the tuned TV signals, that comprises in combination:
- a plurality of processing modules (P1-Pn) in a parallel arrangement, and adapted to simultaneously process analogue or digital input signals of RF channels (CH1-CHn) to be tuned, a channel (CH1-CHn) per processing module (P1-Pn), each one of said processing modules (P1-Pn) providing at least filtering and each one of them comprising at least one variable gain amplifier (10) with an application line (C1-Cn) of gain voltage (Vacg-1 to Vacg-n),
- an automatic gain control circuit (AGC) responsible for processing the output signals of said processing modules (P1-Pn), said output signals corresponding to the channels (CH1-CHn) tuned by each one of them, or samples of the same, to check output levels (L) of the output signals of the processing modules (P1-Pn) and to generate and apply gain voltages (Vacg-1 to Vacg-n) to said application lines (C1-Cn) of said variable gain amplifiers (10) in order to automatically control said output levels (L) of said processing modules (P1-Pn) output signals, until adjusting them to certain predetermined values, hence achieving said control,
- an output or amplification line (2) common to all the processing modules (P1-Pn) outputs, which is connected, directly or through a sample socket (4), to an input of said automatic gain control circuit (AGC), so that all said processing modules (P1-Pn) output signals, or all the samples of said signals, arrive at the same time to the automatic gain control circuit (AGC), which is governed by at least one microcontroller (7) to:
- select one by one, said processing modules (P1-Pn) output signals or said samples, through selection means.
- carry out sequentially at least one processing of each one of said selected signals or samples; and
- carry out sequentially said generation of said gain voltages (Vacg-1 to Vacg-n) from the result of said processing of each signal or sample.

2. Headend according to claim 1, wherein said automatic gain control circuit (AGC) is adapted to carry out said application of gain voltages (Vacg-1 to Vacg-n) to the application lines (C1-Cn) of the variable gain amplifiers (10) in a sequential fashion.

3. Headend, according to claim 1, wherein said automatic gain control circuit (AGC) is adapted to carry out said application of the gain voltages (Vacg-1 to Vacg-n) to the application lines (C1-Cn) of the variable gain amplifiers (10) in a simultaneous fashion.

4. Headend, according to claim 1 or 3, wherein said automatic gain control circuit (AGC) comprises selecting means adapted for selecting, in a sequential manner, said processing modules (P1-Pn) output signals, or said samples of the same, one by one, through a frequency selectivity characteristic sufficient enough to make them independent from the influence of the adjacent channels, at least from n-3 to n+3, being n the nominal channel corresponding to the output signal selected at each moment.

5. Headend, according to claim 4, wherein said automatic gain control circuit (AGC) comprises:
- a Vdc voltages generator block (5) with an input connected to an output common line (120) of the sample socket (4), which is associated to an automatic control system, with at least one microcontroller (7) and one memory (8), to sequentially process said signal samples and to generate and send sequentially, said gain voltages (Vacg-1 to Vacg-n) through an output (16),
- a sampling, holding and addressing block (6) with an input connected to said generator block (5) output (16), and a series of outputs each one of which individually connected to one of said amplification lines (C1-Cn) of the processing modules (P1-Pn), with said block (6) also associated to said automatic control system, and controlled by the same, to sample and temporally hold said gain voltages (Vacg-1 to Vacg-n) and to address them to their corresponding amplification lines (C1-Cn) of the processing modules (P1-Pn).

6. Headend, according to claim 5, wherein said memory (8) stores at least numeric data representative of the headend configuration for at least all the analogue and digital channels (CH1-CHn) to be received by said TV headend, in at least one geographical area, with their corresponding frequencies, with respective division factors, as well as of output signals levels (L) which are pre-established for each analogue or digital channel (CH1-CHn), and respective gain voltages, at least initial gain voltages.

7. Headend, according to claim 6, wherein said automatic control system is adapted for, by means of at least said microcontroller (7), receiving values of Vdc voltage pulses proportional to the values sampled at said samples socket (4) and generated by said generator block (5), for each channel (CH1-CHn), and, after its digitalisation by a corresponding A/D converter (19a), comparing them with said data relative to said levels (L) stored in the memory (8), and depending on the result of said comparisons sending to said generator block (5) digital values referring to said initial or modified gain voltages, that said generator block (5) converts to analogue, through a corresponding D/A converter (19b), and sending them through said output (16).

8. Headend, according to claim 7, wherein said generator block (5) comprises:
- at least part of said selection means comprising at least a frequency synthesiser (17-18), a mixer (13) with an input connected to the output of said synthesiser (17-18) and another input connected to said common line (120) through which the input signals samples are received, a low-pass filter (14) of a cut-off frequency lower than half of the bandwidth of the channel n to be filtered in each moment and blocking a possible DC offset at its input, connected to the output of said mixer (13), simultaneously receiving all the signals corresponding to all the tuned channels (CH1-CHn), said microcontroller (7) also forming part of said selection means to control, through a corresponding output (130), said synthesiser (17-18) in order to supply a series of signals with frequencies equal to the ones of all the channels (CH1-CHn), one by one following an uninterrupted sequence,
- a detector (15) with an input connected to the output of said low-pass filter (14), and an output to said A/D converter (19a).

9. Headend, according to claim 6, wherein said storage memory (8) stores numeric data representative of a plurality of configurations of the headend for analogue and digital channels to be received by said TV headend, in a plurality of geographical areas, with their corresponding frequencies as well as of output signals levels (L) which are pre-established for each channel and some respective initial gain voltages.

10. Headend according to claim 9, wherein said automatic gain control circuit (AGC) further comprises, in association with said microcontroller (7), a display and a keyboard (7a), to respectively visualise at least part of said data corresponding to said plurality of configurations, and select those which correspond to one of said configurations, in order to re-programme the processing modules (P1-Pn) through a corresponding channels reassignment, and their associated data referring to desired levels (L) and corresponding gain voltages, at least initial gain voltages.

## Patentansprüche

1. Kopfteil für den Empfang von Fernsehsignalen über eine Gemeinschaftsantenne oder einen Kabelfernsehanschluss mit automatischer Verstärkungsregelung der Ausgangspegel der eingestellten Fernsehsignale, der folgende Kombination umfasst:
- eine Reihe von Verarbeitungsmodulen (P1-Pn) in einer parallelen Anordnung und angepasst für die gleichzeitige Verarbeitung von analogen oder digitalen Eingangssignalen der einzustellenden Radiofrequenzkanäle (CH1-CHn), einen Kanal (CH1-CHn) pro Verarbeitungsmodul (P1-Pn), wobei jedes der Verarbeitungsmodule (P1-Pn) zumindest das Filtern ermöglicht und jedes von ihnen mindestens einen variablen Regelverstärker (10) mit einer Anwendungsleitung (C1-Cn) der Regelspannung (Vacg-1 bis Vacg-n) umfasst,
- ein automatischer Verstärkungsregelungsschaltkreis (AGC), der für die Verarbeitung der Ausgangssignale der Verarbeitungsmodule (P1-Pn) verantwortlich ist, wobei die Ausgangssignale den auf diesen eingestellten Kanälen (CH1-CHn) entsprechen, oder Proben derselben, um den Ausgangspegel (L) der Ausgangssignale der Verarbeitungsmodule (P1-Pn) zu prüfen und Regelspannungen (Vacg-1 bis Vacg-n) an den Anwendungsleitungen (C1-Cn) der variablen Regelverstärker (10) zu erzeugen und daran anzulegen, um die Ausgangspegel (L) der Ausgangssignale der Verarbeitungsmodule (P1-Pn) automatisch zu steuern, bis diese an bestimmte Vorgabewerte angepasst sind, d. h. die Steuerung erreicht ist,
- eine allen Ausgängen der Verarbeitungsmodule (P1-Pn) gemeinsame Ausgangs- oder Verstärkungsleitung (2), die direkt oder über eine Probebuchse (4) an einem Eingang des automatischen Verstärkungsregelungsschaltkreises (AGC) angeschlossen ist, so dass alle Ausgangssignale der Verarbeitungsmodule (P1-Pn) oder alle Proben dieser Signale gleichzeitig den automatischen Verstärkungsregelungsschaltkreis (AGC) erreichen, der über mindestens einen Mikrocontroller (7) gesteuert wird, um:
- einzeln die Ausgangssignale der Verarbeitungsmodule (P1-Pn) oder Proben über ausgewählte Mittel zu wählen;
- sequenziell zumindest eine Verarbeitung der einzelnen ausgewählten Signale oder Proben vorzunehmen und
- sequenziell die Erzeugung der Regelspannungen (Vacg-1 bis Vacg-n) ausgehend von den Ergebnissen der Verarbeitung der einzelnen Signale oder Proben vorzunehmen.

2. Kopfteil gemäß Anspruch 1, wobei der automatische Verstärkungsregelungsschaltkreis (AGC) so angepasst ist, dass die Beaufschlagung der Regelspannungen (Vacg-1 bis Vacg-n) an die Anwendungsleitungen (C1-Cn) der variablen Regelverstärker (10) sequenziell erfolgt.

3. Kopfteil gemäß Anspruch 1, wobei der automatische Verstärkungsregelungsschaltkreis (AGC) so angepasst ist, dass die Beaufschlagung der Regelspannungen (Vacg-1 bis Vacg-n) auf die Anwendungsleitungen (C1-Cn) der variablen Regelverstärker (10) gleichzeitig erfolgt.

4. Kopfteil gemäß Anspruch 1 oder 3, wobei der automatische Verstärkungsregelungsschaltkreis (AGC) Vorrichtungen zur Auswahl umfasst, die so ausgelegt sind, dass sie sequenziell die Ausgangssignale der Verarbeitungsmodule (P1-Pn) oder deren Proben über eine charakteristische Frequenzauswahlfähigkeit auswählen, die ausreichend ist, um den Einfluss der nebenliegenden Kanäle mindestens von n-3 bis n+3 zu unterdrücken, wobei n der Nominalkanal des jeweils ausgewählten Ausgangssignals ist.

5. Kopfteil gemäß Anspruch 4, wobei der automatische Verstärkungsregelungsschaltkreis (AGC) umfasst:
- einen Block zur Erzeugung von Gleichstromspannungen (5) mit einem Eingang, der an eine gemeinsame Leitung (120) der Probenbuchse (4) angeschlossen ist, die mit einem automatischen Steuerungssystem mit mindestens einem Mikrocontroller (7) und einem Speicher (8) in Verbindung steht, um die Signalproben sequenziell zu verarbeiten und die Regelspannungen (Vacg-1 bis Vacg-n) zu erzeugen und sequenziell über einen Ausgang (16) zu senden,
- einen Block zur Probeentnahme, Halten und Adressierung (6) mit einem Eingang, der am Ausgang (16) des Generatorblocks (5) angeschlossen ist, und einer Reihe von Ausgängen, die jeweils einzeln an eine der Verstärkerleitungen (C1-Cn) der Verarbeitungsmodule (P1-Pn) angeschlossen sind, wobei der Block (6) ebenso mit dem automatischen Steuerungssystem in Verbindung steht und von diesem gesteuert wird, um die Proben zu entnehmen und vorübergehend die Regelspannungen (Vacg-1 bis Vacg-n) zu halten und die Adressierung zu den jeweiligen Verstärkerleitungen (C1-Cn) der Verarbeitungsmodule (P1-Pn) vorzunehmen.

6. Kopfteil gemäß Anspruch 5, wobei der Speicher (8) mindestens nummerische Daten speichert, die die Konfiguration des Kopfteils zumindest aller analoger und digitaler Kanäle (CH1-CHn) darstellen, die vom Fernsehkopfteil in mindestens einem geografischen Bereich empfangen werden sollen, zusammen mit den jeweiligen Frequenzen, mit einigen entsprechenden Teilungsfaktoren sowie den Pegeln der Ausgangssignale (L), die für jeden analogen und digitalen Kanal (CH1-CHn) vorgegeben sind, und die jeweiligen Regelspannungen, zumindest die anfänglichen Regelspannungen.

7. Kopfteil gemäß Anspruch 6, wobei das automatische Steuerungssystem so ausgelegt ist, dass es zumindest über den Mikrocontroller (7), der die Werte der Gleichstromspannungsimpulse proportional zu den an der Probebuchse (4) erfassten und vom Generatorblock (5) erzeugten Proben für jeden Kanal (CH1-CHn) empfängt und nach deren Digitalisierung über den entsprechenden A/D-Wandler (19a) diese mit den Daten der Pegel (L) vergleicht, die im Speicher (8) gespeichert sind, und, je nach Ergebnis des Vergleichs, an den Generatorblock (5) digitale Werte für die anfänglichen oder veränderten Regelspannungen sendet, die der Generatorblock (5) über den entsprechenden D/A-Wandler (19b) in analoge Signale umwandelt und über den Ausgang (16) versendet.

8. Kopfteil gemäß Anspruch 7, wobei der Generatorblock (5) umfasst:
- zumindest einen Teil der Auswahlvorrichtungen, umfassend zumindest einen Frequenzgenerator (17-18), einen Mischer (13) mit einem Eingang, der an den Ausgang des Frequenzgenerators (17-18) und einem anderen Eingang, der an die gemeinsame Leitung (120) angeschlossen ist, über die die Proben der Eingangssignale eingehen, einen Tiefpassfilter (14) mit einer Grenzfrequenz, die niedriger ist als die Hälfte der Bandbreite des jeweils zu filternden Kanals n, der eventuelle Gleichstromverschiebungen unterbindet, angeschlossen an den Ausgang des Mischers (13), der gleichzeitig alle Signale für alle eingestellten Kanäle (CH1-CHn) empfängt, wobei der Mikrocontroller (7) auch Bestandteil der Steuerungsvorrichtung ist, um über den entsprechenden Ausgang (130) den Frequenzgenerator (17-18) zu steuern, damit eine Reihe von Signalen bereit gestellt wird, deren Frequenzen gleich sind wie jene aller Kanäle (CH1-CHn) einzeln in einer fortlaufenden Sequenz,
- einen Wächter (15) mit einem Eingang, der an den Ausgang des Tiefpassfilters (14) angeschlossen ist, und einem Ausgang zum A/D-Wandler (19a).

9. Kopfteil gemäß Anspruch 6, wobei der Speicher (8) nummerische Daten speichert, die mehrere Konfigurationen des Kopfteils für analoge und digitale Kanäle darstellt, die vom Fernsehkopfteil empfangen werden sollen, und das in mehreren geographischen Bereichen, zusammen mit den jeweiligen Frequenzen sowie den Pegeln der Ausgangssignale (L), die für jeden Kanal vorgegeben sind, und einige deren anfänglichen Regelspannungen.

10. Kopfteil gemäß Anspruch 9, wobei der automatische Verstärkungsregelungsschaltkreis (AGC) außerdem in Verbindung mit dem Mikrocontroller (7) ein Display und eine Tastatur (7a) umfasst, um jeweils mindestens einen Teil der Daten der verschiedenen Konfigurationen anzuzeigen und jene auszuwählen, die einer der Konfigurationen entsprechen, mit dem Zweck, die Verarbeitungsmodule (P1-Pn) mit der entsprechenden Neuzuweisung der Kanäle und derer jeweiligen Daten für die gewünschten Pegel (L) und Regelspannungen, zumindest aber der anfänglichen Regelspannungen neu zu programmieren.

## Revendications

1. Tête de réception de signaux TV via une antenne collective ou par réseau câblé de télévision, avec commande de gain automatique des niveaux de sortie des signaux TV accordés, comprenant de façon combinée :
- une pluralité de modules de traitement (P1-Pn) disposés en parallèle et adaptés pour traiter simultanément les signaux d'entrée analogique ou numérique des canaux RF (CH1-CHn) à accorder, un canal (CH1-CHn) par module de traitement (P1-Pn), chacun desdits modules de traitement (P1-Pn) assurant au moins une fonction de filtrage et chacun d'eux comprenant au moins un amplificateur de gain variable (10) avec une ligne d'application (C1-Cn) de tension à gain (Vacg-1 à Vacg-n),
- un circuit à commande de gain automatique (AGC) chargé de traiter les signaux de sortie desdits modules de traitement (P1-Pn), lesdits signaux de sortie correspondant aux canaux (CH1-CHn) accordés par chacun d'eux ou par des échantillons de ceux-ci, pour contrôler les niveaux de sortie (L) des signaux de sortie des modules de traitement (P1-Pn) et pour générer et appliquer des tensions à gain (Vacg-1 à Vacg-n) aux dites lignes d'application (C1-Cn) desdits amplificateurs de gain variable (10) afin de contrôler automatiquement lesdits niveaux de sortie (L) desdits signaux de sortie des modules de traitement (P1-Pn), jusqu'à les régler à certaines valeurs prédéterminées, parvenant ainsi audit contrôle,
- une ligne d'amplification ou sortie (2) commune à toutes les sorties des modules de traitement (P1-Pn), qui est connectée, directement ou via une prise d'échantillonnage (4), à l'une des entrées dudit circuit à commande de gain automatique(AGC), de manière à ce que tous lesdits signaux de sortie des modules de traitement (P1-Pn) ou tous les échantillons desdits signaux, arrivent en même temps au circuit de commande de gain automatique (AGC), qui est piloté par au moins un microcontrôleur (7) pour :
- sélectionner un à un, lesdits signaux de sortie des modules de traitement (P1-Pn) ou lesdits échantillons au moyen de dispositifs de sélection.
- traiter au moins une fois et de manière séquentielle, chacun desdits signaux ou échantillons sélectionnés et
- effectuer de manière séquentielle la génération desdites tensions à gain (Vacg-1 à Vacg-n) à partir du résultat dudit traitement de chaque signal ou échantillon.

2. Tête selon la revendication 1, où ledit circuit de commande de gain automatique (AGC) est adapté pour procéder à ladite application des tensions à gain (Vacg-1 à Vacg-n) aux lignes d'application (C1-Cn) des amplificateurs de gain variable (10) de manière séquentielle.

3. Tête selon la revendication 1, où ledit circuit de commande de gain automatique (AGC) est adapté pour procéder à ladite application des tensions à gain (Vacg-1 à Vacg-n) aux lignes d'application (C1-Cn) des amplificateurs de gain variable (10) de manière simultanée.

4. Tête, selon la revendication 1 ou 3, où ledit circuit de commande de gain automatique (AGC) comprend des dispositifs de sélection adaptés pour sélectionner, de manière séquentielle lesdits signaux de sortie des modules de traitement (P1-Pn) ou lesdits échantillons de ceux-ci, un à un, via une caractéristique de sélectivité de fréquence suffisante pour sous-estimer l'influence des canaux adjacents, de n-3 à n+3 au moins, n étant le canal nominal correspondant au signal de sortie sélectionné à chaque moment.

5. Tête, selon la revendication 4, où ledit circuit de commande de gain automatique (AGC) comprend :
- un bloc générateur de tensions Vcc (5) dont l'entrée est connectée à une ligne commune de sortie (120) de la prise d'échantillonnage (4) elle-même associée à un système de commande automatique, avec au moins un microcontrôleur (7) et une mémoire (8)pour traiter de manière séquentielle lesdits échantillons de signal et pour générer et envoyer de manière séquentielle lesdites tensions à gain (Vacg-1 à Vacg-n) via une sortie (16),
- un bloc d'échantillonnage, de maintien et d'adressage (6) dont l'orifice d'entrée est connecté à l'orifice de sortie (16) dudit bloc générateur (5) et une série d'orifices de sortie étant chacun d'eux connectés aux dites lignes d'amplification (C1-Cn) des modules de traitement (P1-Pn) avec ledit bloc (6) également associé audit système de commande automatique et contrôlé par celui-ci pour échantillonner et maintenir temporairement lesdites tensions à gain (Vacg-1 à Vacg-n) et pour les adresser aux lignes d'amplification (C1-Cn) correspondantes des modules de traitement (P1-Pn).

6. Tête, selon la revendication 5, où ladite mémoire (8) stocke au moins des données numériques représentatives de la configuration de la tête pour au moins tous les canaux analogiques et numériques (CH1-CHn) devant être reçus par ladite tête TV, dans au moins une zone géographique, avec leurs fréquences correspondantes, avec certains facteurs de division respectifs, ainsi que des niveaux de signaux de sortie (L) qui sont préétablis pour chaque canal analogique ou numérique (CH1-CHn) et des tensions à gain respectives, étant au minimum des tensions à gain initiales.

7. Tête, selon la revendication 6, où ledit système de commande automatique est adapté, au moyen du microcontrôleur (7), pour recevoir les valeurs des impulsions de tension Vcc proportionnelles aux valeurs échantillonnées à ladite prise d'échantillonnage (4) et générées par ledit bloc générateur (5) pour chaque canal (CH1-CHn) et après leur numérisation par un convertisseur analogique/numérique correspondant (19a), en les comparant avec lesdites données relatives aux dits niveaux (L) mis en mémoire (8) et en fonction du résultat de ces comparaisons en envoyant audit bloc générateur (5) des valeurs numériques faisant référence aux dites tensions à gain initiales ou modifiées que ledit bloc générateur (5) convertit en données analogiques, via un convertisseur A/N correspondant (19b) et en les transmettant via ladite sortie (16).

8. Tête, selon la revendication 7, où ledit bloc générateur (5) comprend :
- au moins une partie dudit dispositif de sélection comprenant au moins un synthétiseur de fréquence (17-18), un mélangeur (13) dont l'orifice d'entrée est relié à l'orifice de sortie du synthétiseur (17-18) et un autre orifice d'entrée relié à ladite ligne commune (120) via laquelle les échantillons de signaux d'entrée sont reçus, un filtre passe-bas (14) d'une fréquence coupée inférieure à la moitié de la bande passante du canal n à filtrer à chaque moment et bloquant un éventuel décalage CC à son orifice d'entrée, connecté à l'orifice de sortie dudit mélangeur (13), recevant simultanément tous les signaux correspondant à tous les canaux (CH1-CHn), ledit microcontrôleur (7) faisant également partie dudit dispositif de sélection pour contrôler, via un orifice de sortie correspondant (130), le synthétiseur (17-18) afin de générer une série de signaux à des fréquences égales à celles de tous les canaux (CH1-CHn), un à un, en suivant une séquence ininterrompue,
- un détecteur (15) dont l'orifice d'entrée est connecté à l'orifice de sortie dudit filtre passe-bas (14) et dont l'orifice de sortie est connecté audit convertisseur A/N (19a).

9. Tête, selon la revendication 6, où ladite mémoire de stockage (8) emmagasine les données numériques représentatives d'une pluralité de configurations de la tête pour des canaux analogiques et numériques devant être reçus par ladite tête TV, dans une pluralité de zones géographiques, avec leurs fréquences correspondantes ainsi que des niveaux (L) des signaux de sortie qui sont préétablis pour chaque canal et pour certaines tensions à gain initiales respectives.

10. Tête, selon la revendication 9, où ledit circuit de commande de gain automatique (AGC) comprend en plus du microcontrôleur (7), un écran et un clavier (7a), pour visualiser au moins une partie desdites données correspondant à ladite pluralité de configurations et sélectionner celles qui correspondent à l'une desdites configurations, afin de reprogrammer les modules de traitement (P1-Pn) via une réassignation des canaux, et leurs données correspondantes faisant référence à des niveaux (L) souhaités et à des tensions à gain correspondantes étant au minimum, des tensions à gain initiales.
